# EUROPÄISCHE PATENTANMELDUNG

(11) **EP 4 358 661 A1**
(43) Veröffentlichungstag der Anmeldung: **24.04.2024**
(21) Anmeldenummer: 23197903.0
(22) Anmeldetag: 18.09.2023
(51) Int. Cl.: H05K 7/14

(54) **FELDGERÄT UND VERFAHREN ZUR KOMPAKTEN ANORDNUNG VON ELEKTRONISCHEN BAUGRUPPEN EINER ELEKTRONIKSCHALTUNG**

(30) Priorität: 21.10.2022 DE 102022127941
(71) Anmelder: VEGA Grieshaber KG, 77709 Wolfach (DE)
(72) Erfinder: ILG, Thomas, 77716 Haslach (DE); ISENMANN, Marius, 77781 Biberach (DE)
(74) Vertreter: Maiwald GmbH

(57) **Zusammenfassung**

Feldgerät zur Prozessautomatisierung im industriellen oder privaten Umfeld, aufweisend eine Elektronikschaltung zur Steuerung des Feldgeräts, wobei die Elektronikschaltung eine erste, eine zweite und eine dritte Leiterplatte aufweist. Die erste Leiterplatte ist mit der zweiten Leiterplatte und/oder mit der dritten Leiterplatte mittels einer elektrischen Steckverbindung verbunden und daran befestigt, wobei sich die zweite Leiterplatte oberhalb der dritten Leiterplatte befindet.

## Beschreibung

### Bezugnahme auf verwandte Anmeldung

Die vorliegende Anmeldung beansprucht die Priorität der deutschen Patentanmeldungen Nr. 10 2022 127 941.3, eingereicht am 21. Oktober 2022, die in vollem Umfang durch Bezugnahme in das vorliegende Dokument aufgenommen wird.

### Technisches Gebiet

Die Erfindung betrifft ein Feldgerät zur Prozessautomatisierung im industriellen oder privaten Umfeld sowie ein Verfahren zur kompakten Anordnung von elektronischen Baugruppen einer Elektronikschaltung eines Feldgeräts.

### Technischer Hintergrund

In der Prozessautomatisierung im industriellen oder privaten Umfeld werden Feldgeräte eingesetzt, die zur Erfassung von Prozessmessgrößen, wie Füllstand, Durchfluss, Temperatur oder Druck, eingerichtet sind. Diese Feldgeräte weisen eine Elektronikschaltung auf, die zur Steuerung des Feldgeräts eingerichtet ist. Diese weist im Regelfall eine oder mehrere Leiterplatten auf, die parallel zueinander angeordnet und elektrisch miteinander verbunden sind.

### Zusammenfassung

Es ist eine Aufgabe der vorliegenden Erfindung, ein Feldgerät bereitzustellen, das eine alternative Elektronikschaltung aufweist.

Diese Aufgabe wird durch die Merkmale der unabhängigen Patentansprüche gelöst. Weitere Ausführungsformen der vorliegenden Offenbarung ergeben sich aus den Unteransprüchen der folgenden Beschreibung.

Ein erster Aspekt der vorliegenden Offenbarung betrifft ein Feldgerät zur Prozessautomatisierung im industriellen oder privaten Umfeld, welches eine Elektronikschaltung aufweist, die zur Steuerung des Feldgeräts eingerichtet ist.

Die Elektronikschaltung weist zumindest eine erste Leiterplatte, eine zweite Leiterplatte und eine dritte Leiterplatte auf. Die erste Leiterplatte ist mit der zweiten Leiterplatte und/oder mit der dritten Leiterplatte mittels einer oder mehreren elektrischen Steckverbindungen verbunden und daran befestigt. Hierbei befindet sich die zweite Leiterplatte oberhalb der dritten Leiterplatte. "Oberhalb" kann beispielsweise "auf der dem Prozess abgewandten Seite" bedeuten. Auch kann eine Anordnung vorgesehen sein, die spiegelverkehrt zu der oben beschriebenen Anordnung an Leiterplatten aufgebaut ist.

Die Leiterplatten können über Stift- und Steckerleisten (elektrische Steckverbindung) miteinander verbunden werden. Ist keine elektrische Steckverbindung vorgesehen, können Flachbandleitungen oder direkt verbindende Flexleiter, Semiflex oder dergleichen eingesetzt werden, um die Leiterplatten elektrisch zu verbinden. Auch können rechtwinklige Stift- und Steckerleisten eingesetzt werden, die es ermöglichen, auf jedem Ort der Leiterplatte eine weitere Leiterplatte im 90 Grad-Winkel zu platzieren.

Die in dem Feldgerät vorgesehene Elektronikschaltung ermöglicht eine kompakte Anordnung von elektronischen Baugruppen unter Einsparung von elektrischen Kontakten zum Beispiel einer Flachbandleitung.

Gemäß einer Ausführungsform sind die zweite Leiterplatte und die dritte Leiterplatte parallel zueinander angeordnet. Dies reduziert Bauhöhe.

Gemäß einer weiteren Ausführungsform sind die erste Leiterplatte und die zweite Leiterplatte spaltfrei und/oder senkrecht zueinander angeordnet. Die spaltfreie Anordnung spart ebenfalls Bauraum und kann die mechanische Stabilität erhöhen.

Gemäß einer weiteren Ausführungsform ist die erste Leiterplatte an der zweiten Leiterplatte und/oder der dritten Leiterplatte ausschließlich mittels der elektrischen Steckverbindung befestigt. Im Falle der Befestigung der ersten Leiterplatte an sowohl der zweiten als auch der dritten Leiterplatte können zwei Steckverbindungen vorgesehen sein.

Gemäß einer weiteren Ausführungsform umfasst die elektrische Steckverbindung zumindest einen Stecker und zumindest eine Buchse, wobei der Stecker an der ersten Leiterplatte angebracht ist (oder an der zweiten Leiterplatte oder der dritten Leiterplatte) und die Buchse an der zweiten Leiterplatte (oder der dritten Leiterplatte bzw. an der ersten und der dritten bzw. der ersten und der zweiten).

Gemäß einer weiteren Ausführungsform weist die zweite Leiterplatte eine Durchführung auf, durch welche die Stifte des Steckers hindurchgeführt sind, um in die dahinter (also auf der anderen Seite der zweiten Leiterplatte) angeordnete Buchse eingesteckt zu sein.

Gemäß einer weiteren Ausführungsform weist die erste Leiterplatte ein Funkmodul auf.

Gemäß einer weiteren Ausführungsform weist die zweite Leiterplatte ein Netzteil auf und/oder die dritte Leiterplatte einen Hauptprozessor.

Gemäß einer weiteren Ausführungsform ist zumindest eine vierte Leiterplatte vorgesehen, die unterhalb der dritten Leiterplatte und parallel dazu angeordnet ist.

Gemäß einer weiteren Ausführungsform weist die vierte Leiterplatte die Sensorik des Feldgeräts auf. Die Sensorik kann aber auch in der dritten Leiterplatte untergebracht sein.

Gemäß einer weiteren Ausführungsform sind die zweite Leiterplatte und die dritte Leiterplatte über eine Kabelverbindung und/oder eine Steckverbindung elektrisch miteinander verbunden. Ebenso können die dritte und die vierte Leiterplatte über eine weitere Kabelverbindung miteinander elektrisch verbunden sein.

Gemäß einer weiteren Ausführungsform sind die erste Leiterplatte und die zweite Leiterplatte und/oder die erste Leiterplatte und die dritte Leiterplatte ausschließlich über die elektrische Steckverbindung elektrisch miteinander verbunden. Eine zusätzliche Kabelverbindung ist nicht vorgesehen.

Gemäß einer weiteren Ausführungsform handelt es sich bei dem Feldgerät um ein Füllstandmessgerät, einen Grenzstandsensor, ein Durchflussmessgerät oder einen Drucksensor.

Gemäß einer weiteren Ausführungsform ist das Feldgerät ein autarkes, drahtlos einsetzbares Feldgerät, welches seine eigene Energieversorgung aufweist und nicht über ein Kabel mit einem externen Gerät oder einem Busnetzwerk verbunden ist.

Ein weiterer Aspekt der vorliegenden Offenbarung betrifft ein Verfahren zur kompakten Anordnung von elektrischen Baugruppen einer Elektronikschaltung eines Feldgeräts, wobei die Elektronikschaltung zumindest eine erste Leiterplatte, eine zweite Leiterplatte und eine dritte Leiterplatte umfasst. Bei dem Verfahren wird eine zweite Leiterplatte mit einer dritten Leiterplatte mittels einer Kabelverbindung elektrisch verbunden. Die zweite Leiterplatte wird parallel zur dritten Leiterplatte angeordnet. Eine erste Leiterplatte wird über der zweiten Leiterplatte angeordnet. Bei dieser Anordnung erfolgt ein elektrisches Verbinden der ersten Leiterplatte mit der zweiten Leiterplatte und/oder mit der dritten Leiterplatte mittels einer elektrischen Steckverbindung bzw. mehreren elektrischen Steckverbindungen.

Im Folgenden werden mit Verweis auf die Figuren Ausführungsformen der vorliegenden Offenbarung beschrieben. Die Darstellungen in den Figuren sind schematisch und nicht maßstäblich. Werden in der folgenden Figurenbeschreibung die gleichen Bezugszeichen verwendet, so beschreiben diese gleiche oder ähnliche Elemente.

### Kurze Beschreibung der Figuren

Fig. 1 zeigt eine Elektronikschaltung eines Feldgeräts gemäß einer Ausführungsform.
Fig. 2 zeigt die Verschaltung der einzelnen Einheiten einer Elektronikschaltung gemäß einer Ausführungsform.
Fig. 3a, Fig. 3b und Fig. 3c zeigen einzelne Schritte eines Verfahrens gemäß einer Ausführungsform.
Fig. 4a, Fig. 4b und Fig. 4c zeigen drei Ausführungsformen einer Elektronikschaltung.
Fig. 5 zeigt ein Beispiel für ein Feldgerät mit einer Elektronikschaltung gemäß einer Ausführungsform.
Fig. 6 zeigt ein Flussdiagramm eines Verfahrens gemäß einer Ausführungsform.

### Detaillierte Beschreibung von Ausführungsformen

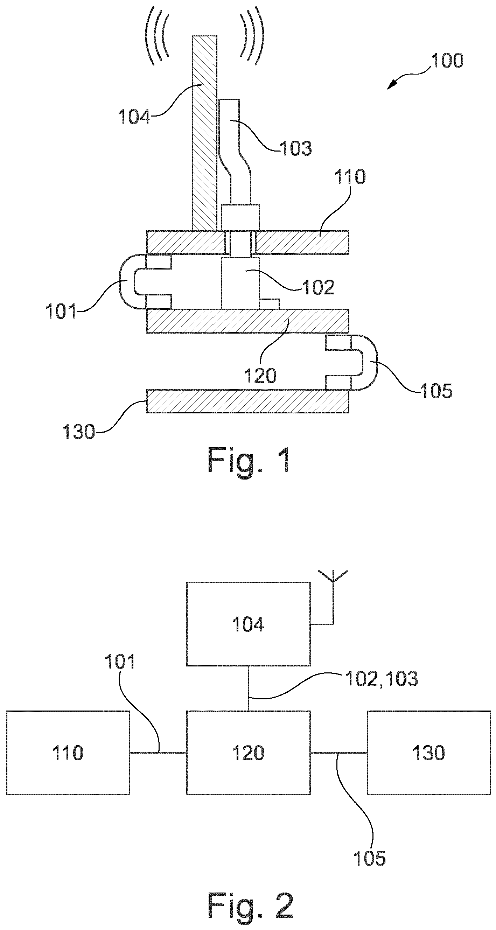

Fig. 1 zeigt eine Elektronikschaltung 100 eines Feldgeräts, das typischerweise zur Prozessautomatisierung im industriellen und/oder privaten Umfeld eingerichtet ist und dort eingesetzt wird. Die Elektronikschaltung weist zumindest eine erste Leiterplatte 104, eine zweite Leiterplatte 110 und eine dritte Leiterplatte 120 auf. In der Ausführungsform der Fig. 1 ist darüber hinaus eine vierte Leiterplatte 130 vorgesehen. Es können auch weitere Leiterplatten vorgesehen sein.

Die erste Leiterplatte 104 ist mit der zweiten Leiterplatte 110 mittels einer elektrischen Steckverbindung 102, 103 verbunden und daran befestigt. Die in der Fig. 1 gezeigte elektrische Steckverbindung 102, 103 weist einen Stecker 103 auf, der an der ersten Leiterplatte 104 befestigt ist und eine Buchse 102, die an der dritten Leiterplatte befestigt ist. Der Stecker 103 ist in die Buchse 102 eingesteckt und durch eine Aussparung in der zweiten Leiterplatte 110 hindurchgeführt. Ein Steg des Steckers 103 kann hierbei auf der Oberseite der zweiten Leiterplatte 110 aufliegen. Ebenso liegt die untere Stirnseite der ersten Leiterplatte 104 auf der Oberseite der zweiten Leiterplatte 110 auf, sodass die Anordnung erste Leiterplatte 104/zweite Leiterplatte 110 spaltfrei ist. Buchse 102 und Stecker 103 können auch umgekehrt angeordnet sein, dass also die Buchse 102 mit der ersten Leiterplatte 104 verbunden ist bzw. daran angebracht ist und der Stecker 103 an der dritten Leiterplatte angebracht ist, sodass er von unten die zweite Leiterplatte 110 durchdringt. Mechanisch ist dies insbesondere möglich, wenn die Flachbandleitung 101 weit genug weg von der Durchdringungsstelle der Leiterplatte 110 angeordnet ist.

Auch kann vorgesehen sein, dass die Buchse 102 an der vierten Leiterplatte 130 befestigt ist, sodass in diesem Falle zwei Aussparungen vorgesehen sind, eine in der zweiten Leiterplatte 110 und eine zweite in der dritten Leiterplatte 120, die von dem Stecker durchdrungen werden.

Es können auch zwei Steckverbindungen vorgesehen sein, eine zur Verbindung der ersten Leiterplatte mit der dritten Leiterplatte und eine zweite zur Verbindung der ersten Leiterplatte mit der zweiten Leiterplatte oder der vierten Leiterplatte.

Bei der Elektronikschaltung 100 kann es sich um die Hauptelektronik eines Füllstandsensors handeln, die über ein zusätzliches Kommunikationsmodul (Funkmodul) verfügt, über welche die Hauptelektronik parametriert und somit eingestellt werden kann.

Das Funkmodul kann über den Standard Bluetooth verfügen oder einen anderen Funkstandard verwenden, wie beispielsweise LoRa, WLAN, Zigbee, ...

Die Elektronikschaltung 100 besteht beispielsweise aus drei oder mehr Leiterplatten 110, 120, 130 sowie der Leiterplatte für das Kommunikationsmodul 104. Es können auch mehrere Leiterplatten 104 vorgesehen sein. Das Kommunikationsmodul kann als Funkmodul ausgebildet sein. Es kann aber auch als kabelgebiundenes Kommunikationsmodul ausgebildet sein.

Möglich ist z.B. auch eine Leuchtanzeige ("Kommunikationsmodul" zum Menschen).

So kann eine LED vorgesehen sein, um in einem gewissen Bereich den Gehäuses eine Rückmeldung an den Kunden zu geben.

In der Ausführungsform der Fig. 1 erfolgt die elektrische Kontaktierung der ersten Leiterplatte 104 mit der dritten Leiterplatte 120 allein mittels der elektrischen Steckverbindung 102, 103. Die elektrische Verbindung zwischen der zweiten Leiterplatte 110 und der dritten Leiterplatte 120 erfolgt über eine Flachbandleitung 101 oder eine entsprechende Leitungsanordnung, wie bespielsweise eine Stiftleiste. Die elektrische Verbindung zwischen der dritten Leiterplatte 120 und der vierten Leiterplatte 130 erfolgt ebenfalls über eine Flachbandleitung 105 oder eine entsprechende Leitungsanordnung.

Die Leitungsanordnung 101 ist auf einer Seite der Elektronikschaltung vorgesehen und die zweite Leitungsanordnung 105 auf der gegenüberliegenden Seite.

Das Kommunikationsmodul, das durch die erste Leiterplatte 104 bereitgestellt wird, ist somit stehend auf der zweiten Leiterplatte 110 positioniert, beispielsweise in einem 90 Grad-Winkel hierzu. Auf diese Weise wird eine seitliche Abstrahlung des Kommunikationssignals erleichtert.

Um ausreichend Fläche für die übrigen Komponenten der Hauptelektronik zu schaffen, wurden diese auf mehrere, übereinander angeordnete Leiterplatten 110, 120, 130 verteilt, die über Kabelverbindungen 101, 105, beispielsweise in Form von Flachbandleitungen, miteinander verbunden sind. Es können auch weitere Leiterplatten darunter vorgesehen sein.

Der Zugang zur Elektronikschaltung 100 erfolgt von oben. Aufgrund der Anordnung der elektronischen Komponenten von oben nach unten kann vorteilhafterweise vorgesehen sein, das Netzteil auf der zweiten Leiterplatte 110 zu platzieren und den Hauptprozessor auf der dritten Leiterplatte 120. Auf der vierten Leiterplatte 130 kann in diesem Beispiel die Sensorik des Feldgeräts angeordnet sein.

Das Kommunikationsmodul (erste Leiterplatte 104) ist auf direktem Weg mit der Hauptelektronik verbunden, insbesondere mit dem Hauptprozessor, der sich auf der dritten Leiterplatte 120 befindet.

Wird das Kommunikationsmodul 104 mit der zweiten Leiterplatte 110 oder der vierten Leiterplatte 130 verbunden, können zusätzliche Verbindungen über die Flachbandleitungen 101 bzw. 105 verlegt werden.

Hinzu kommt ein weiterer Aspekt: Werden Leiterplatten im rechten Winkel auf anderen Leiterplatten montiert und elektrisch verbunden, so ist dies kaum spaltfrei zu bewerkstelligen. Der Grund dafür ist, dass die überstehende Stiftleiste auf der Gegenseite eine Buchse erfordert. Soll auf den Spalt verzichtet werden, muss auf der zugesteckten Leiterplatte eine größere Fläche reserviert werden.

Um diese beiden Probleme zu vermeiden, werden die Stifte des Steckers der einzusteckenden Leiterplatte 104 durch die zweite Leiterplatte 110 hindurchgeführt und auf der darunterliegenden Leiterplatte 120 montiert.

Diese Bauart spart Kontakte auf der Flachbandleitung, was vorteilhaft ist, um diese möglichst schmal ausführen zu können. Sie sorgt zudem dafür, dass die elektrischen Kontakte nicht über die verbindende Flachbandleitung oder eine Stiftleiste, welche die beiden Leiterplatten 110 und 120 verbindet, geführt werden müssen und die elektrische Leitungslänge damit kürzer ist.

Diese Anordnung spart aufgrund der Spaltfreiheit und dem "Hindurchstecken" der Stiftleiste durch die Leiterplatte 110 Bauhöhe. Auch werden Kontakte auf der Fachbandleitung reduziert. Die Anordnung des Kommunikationsmoduls 104 ist rechtwinklig über der Hauptplatine (zweite Leiterplatte 110). Auch ist eine parallele Anordnung möglich.

Das Feldgerät kann derart eingerichtet sein, dass ein freistehendes Rundum-Senden durch das Kommunikationsmodul 104 möglich ist. Beispielsweise wird dies ermöglicht, indem die erste Leiterplatte 104 senkrecht zur zweiten Leiterplatte 110 angeordnet ist. Die gesamte Kontakt- und Durchtauchstelle der elektrischen Steckverbindung 102, 103 kann vergossen sein, auch um Korrosion und ungewollte Leitung von Strom durch die Leiterplatten zu verhindern.

In der Ausführungsform der Fig. 1 werden Lücken zwischen der ersten Leiterplatte 104, 110 vermieden und aufgrund der 90 Grad-Anordnung kann das Funksignal (auch) seitlich abgestrahlt werden. Weiterhin werden Kontakte der Flachbandleitungen reduziert.

Fig. 1 zeigt eine gute Übersicht über den gesamten mechanischen Aufbau der Elektronikschaltung 100 mit der auf drei Leiterplatten 110, 120, 130 verteilten Hauptelektronik, den verbindenden Flachbandleitungen 101, 105, sowie dem Kommunikationsmodul (erste Leiterplatte 104) mit der Steckverbindung 102, 103 zur Hauptelektronik.

Fig. 2 zeigt eine logische Übersicht der elektrischen Verbindungen der in der Fig. 1 beschriebenen Anordnung. Die erste Leiterplatte 104 ist über die elektrische Steckverbindung 102, 103 an die dritte Leiterplatte 120 angeschlossen. Die dritte Leiterplatte ist über die Kabelverbindung 101 an die zweite Leiterplatte 110 angeschlossen und über die Kabelverbindung 105 an die vierte Leiterplatte 130. Die Kabelverbindungen 101, 105 können flexibel, biegsam ausgeführt sein.

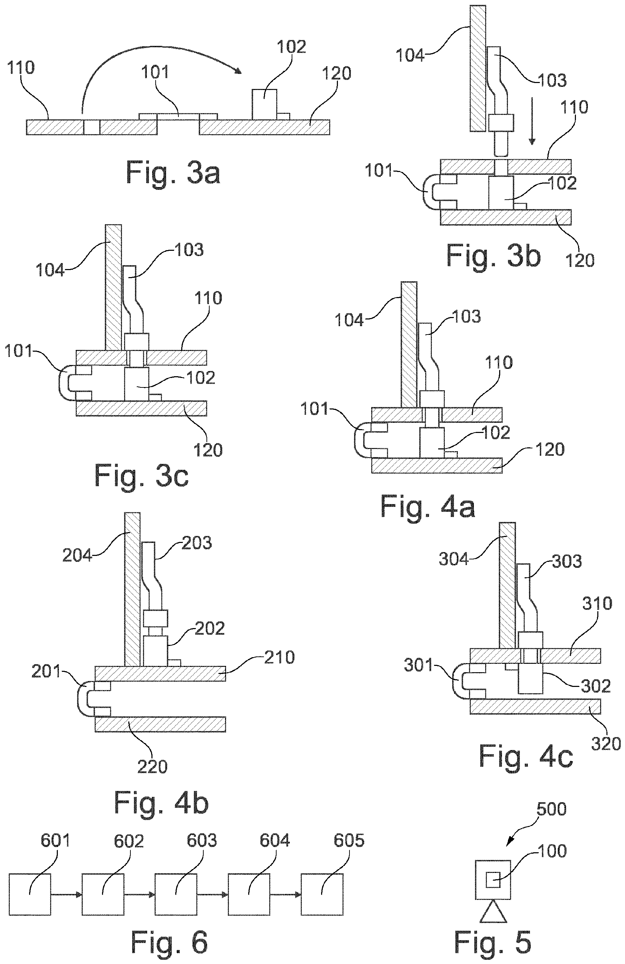

Die Figs. 3a, 3b und 3c zeigen ein Beispiel für den Zusammenbau der Elektronikschaltung 100. Die beiden Leiterplatten 110, 120 sind über die Kabelverbindung 101 miteinander verbunden und zunächst auf derselben Ebene angeordnet (Fig. 3a). Diese Anordnung wird dann "gefaltet", indem die Leiterplatte 110 nach oben geklappt wird, in Pfeilrichtung. Auf der Leiterplatte 120 ist eine Buchse 102 angebracht. Beispielsweise liegt die Leiterplatte 110 nach dem Faltvorgang auf der Buchse auf (Fig. 3b). Es kann aber auch ein Spalt vorgesehen sein. Anschließend wird der Stecker 103 der Leiterplatte 104 von oben mit seiner Stiftleiste durch die Aussparung in der Leiterplatte 110 hindurchgeführt und in die Buchse 102 der Leiterplatte 120 eingesteckt. Hierdurch ergibt sich ein kompakter Zusammenbau (siehe Fig. 3c). Nicht dargestellt ist die Leiterplatte 130 und ggf. weiter Leiterplatten, die vorgesehen sein können.

Die Figuren 4a bis 4c zeigen verschiedene Verfahren zur Verbindung zweier Leiterplatten im 90 Grad-Winkel. Nicht dargestellt sind weitere ggf. vorgesehene Leiterplatten, wie Leiterplatte 130.

Die in den Figuren 4a bis 4c gezeigten Leiterplatten können gleich oder ähnlich bestückt sein. Hierunter ist zu verstehen, dass die Leiterplatte 104 gleich oder ähnlich bestückt sein kann wie die Leiterplatten 204, 304, dass die Leiterplatte 110 gleich oder ähnlich bestückt sein kann wie die Leiterplatten 210, 310 und dass die Leiterplatte 120 ähnlich oder gleich bestückt sein kann wie die Leiterplatten 220, 320.

In der Ausführungsform der Fig. 4a wird die Buchse 102 direkt auf die Leiterplatte 120 bestückt. Zusätzliche Kontakte über die Flachbandleitung 101 entfallen.

In der Fig. 4b erfolgt die elektrische Verbindung durch die oben bestückte Buchse 202 auf der Leiterplatte 210 (also der zweiten Leiterplatte) und nach oben gezogene Stiftleiste 203 auf der ersten Leiterplatte 204. Zusätzliche Leitungen in Richtung der Leiterplatte 220 (dritte Leiterplatte) können über eine Flachbandleitung 201 geführt werden. Die Stiftleiste 203 benötigt im Vergleich zur Ausführungsform der Fig. 4a zusätzliche Fläche auf der Leiterplatte 204.

In der Fig. 4 c ist die Verbindungsbuchse 302 umgekehrt auf der Leiterplatte 310 bestückt. Die Stiftleiste 303 wird durch die Leiterplatte 310 hindurch in die Buchse 302 eingesteckt. Zusätzliche Leitungen in Richtung der Leiterplatte 320 können über eine Flachbandleitung 301 oder eine Stiftleiste geführt werden.

Die beiden Leiterplatten 104, 110 bzw. 204, 210 bzw. 304, 310 können zusammengelötet werden, z. B. über das Eck.

Fig. 5 zeigt ein Feldgerät 500 mit einer Elektronikschaltung 100 gemäß einer Ausführungsform. Bei dem Feldgerät handelt es sich beispielsweise um ein Füllstandmessgerät, insbesondere um ein Füllstandradarmessgerät, um einen Grenzstandsensor, ein Druckmessgerät oder ein Durchflussmessgerät.

Das Feldgerät 500 weist ein Gehäuse auf, in dem sich ein Elektronikbecher befindet. In dem Elektronikbecher befindet sich die Elektronikschaltung 100. Der Elektronikbecher, der im übrigen Teil des Feldgerätegehäuses sein kann, hält die Elektronikschaltung 100. Insbesondere können seitliche Führungen vorgesehen sein, welche die erste Leiterplatte 204 bei ihrer Abwärtsbewegung zum Einstecken in die Buchse 102 führen. In anderen Worten kann die erste Leiterplatte 104 verschiebbar im Feldgerätegehäuse angeordnet sein. Insbesondere kann sie auf diese Weise leicht ausgewechselt oder nachgerüstet werden.

An dieser Stelle sei darauf hingewiesen, dass es auch vorgesehen sein kann, dass die erste Leiterplatte 104 waagrecht, parallel zur zweiten Leiterplatte 110 angeordnet ist. In dieser Anordnung ist der Stecker 103 nicht parallel, sondern senkrecht zur ersten Leiterplatte 104 angeordnet. Dies spart weiteren Bauraum nach oben.

Fig. 6 zeigt ein Flussdiagramm eines Verfahrens gemäß einer Ausführungsform. In Schritt 601 wird eine zweite Leiterplatte 110 mit einer dritten Leiterplatte 120 mittels einer Kabelverbindung 101 elektrisch verbunden. Danach wird die zweite Leiterplatte 110 nach oben umgeklappt, sodass sie nun über der dritten Leiterplatte 120 und parallel dazu angeordnet ist (Schritte 601, 602). In Schritt 603 wird eine erste Leiterplatte 104 über der zweiten Leiterplatte 110 angeordnet, entweder parallel oder senkrecht dazu, oder in einem anderen Winkel. Diese beiden Leiterplatten 104, 110 werden nun aufeinander zubewegt, sodass der Stecker 103 der ersten Leiterplatte 104 in die Steckerbuchse 102 eingeführt wird. In Schritt 605 (dieser Schritt kann auch vor dem Schritt 604 erfolgen) wird die Elektronikschaltung 100 oder, falls dieser Schritt vor dem Schritt 604 erfolgt, werden die zweite Leiterplatte 110 und die dritte Leiterplatte 120 in das Gehäuse des Messgeräts eingeführt und dort befestigt. Im letzteren Fall kann daraufhin die erste Leiterplatte 204 von oben eingeschoben werden.

Die in den Ansprüchen verwendeten Begriffe sollten so ausgelegt werden, dass sie die weitestmögliche vernünftige Interpretation in Übereinstimmung mit der vorstehenden Beschreibung erhalten, insbesondere der Begriff "Leiterplatte". Zum Beispiel sollte die Verwendung des Artikels "ein" oder "der" bei der Einführung eines Elements nicht so ausgelegt werden, dass sie eine Vielzahl von Elementen ausschließt. Ebenso sollte die Erwähnung von "oder" so ausgelegt werden, dass sie eine Vielzahl von Elementen einschließt, so dass die Erwähnung von "A oder B" nicht "A und B" ausschließt, es sei denn, aus dem Kontext oder der vorangehenden Beschreibung geht klar hervor, dass nur eines von A und B gemeint ist. Ferner ist die Formulierung "mindestens eines von A, B und C" als eines oder mehrere Elemente aus einer Gruppe von Elementen zu verstehen, die aus A, B und C besteht, und nicht so auszulegen, dass mindestens eines von jedem der aufgeführten Elemente A, B und C erforderlich ist, unabhängig davon, ob A, B und C als Kategorien oder auf andere Weise miteinander verbunden sind. Darüber hinaus sollte die Erwähnung von "A, B und/oder C" oder "mindestens eines von A, B oder C" so ausgelegt werden, dass sie jede einzelne Einheit der aufgeführten Elemente, z. B. A, jede Teilmenge der aufgeführten Elemente, z. B. A und B, oder die gesamte Liste der Elemente A, B und C umfasst.

## Patentansprüche

1. Feldgerät (500) zur Prozessautomatisierung im industriellen oder privaten Umfeld, aufweisend:
eine Elektronikschaltung (100), eingerichtet zur Steuerung des Feldgeräts;
wobei die Elektronikschaltung eine erste Leiterplatte (104), eine zweite Leiterplatte (110) und eine dritte Leiterplatte (120) aufweist;
wobei die erste Leiterplatte mit der zweiten Leiterplatte und/oder mit der dritten Leiterplatte mittels einer elektrischen Steckverbindung (102, 103) verbunden und daran befestigt ist;
wobei sich die zweite Leiterplatte oberhalb der dritten Leiterplatte befindet.

2. Feldgerät (500) nach Anspruch 1,
wobei die zweite Leiterplatte (110) und die dritte Leiterplatte (120) parallel zueinander angeordnet sind.

3. Feldgerät (500) nach einem der vorhergehenden Ansprüche,
wobei die erste Leiterplatte (104) und die zweite Leiterplatte (110) spaltfrei und/oder senkrecht zueinander angeordnet sind.

4. Feldgerät (500) nach einem der vorhergehenden Ansprüche,
wobei die erste Leiterplatte (104) an der zweiten Leiterplatte (110) und/oder der dritten Leiterplatte (120) ausschließlich mittels der elektrischen Steckverbindung (102, 103) befestigt ist.

5. Feldgerät (500) nach einem der vorhergehenden Ansprüche,
wobei die elektrische Steckverbindung (102, 103) einen Stecker (103) und eine Buchse (102) umfasst;
wobei der Stecker an der ersten Leiterplatte (104) angebracht ist und die Buchse an der zweiten oder dritten Leiterplatte (110, 120) angebracht ist, oder umgekehrt.

6. Feldgerät (500) nach Anspruch 5,
wobei die zweite Leiterplatte (110) eine Durchführung aufweist, durch welche die Stifte des Steckers (103) hindurchgeführt sind, um in die dahinter angeordnete Buchse (102) eingesteckt zu sein.

7. Feldgerät (500) nach einem der vorhergehenden Ansprüche,
wobei die erste Leiterplatte (4) ein Funkmodul aufweist.

8. Feldgerät (500) nach einem der vorhergehenden Ansprüche,
wobei die zweite Leiterplatte (110) ein Netzteil aufweist; und/oder
wobei die dritte Leiterplatte (120) einen Hauptprozessor aufweist.

9. Feldgerät (500) nach einem der vorhergehenden Ansprüche, weiter aufweisend:
zumindest eine vierte Leiterplatte (130), die unterhalb der dritten Leiterplatte (120) und parallel dazu angeordnet ist.

10. Feldgerät (500) nach Anspruch 9,
wobei die vierte Leiterplatte (130) die Sensorik des Feldgeräts aufweist.

11. Feldgerät (500) nach einem der vorhergehenden Ansprüche,
wobei die zweite Leiterplatte (110) und die dritte Leiterplatte (120) über eine Kabelverbindung (101) elektrisch miteinander verbunden sind.

12. Feldgerät (500) nach einem der Ansprüche 2 bis 10,
wobei die erste Leiterplatte (104) und die zweite Leiterplatte (110) und/oder die erste Leiterplatte (104) und die dritte Leiterplatte (120) ausschließlich über die elektrische Steckverbindung (102, 103) elektrisch miteinander verbunden sind.

13. Feldgerät (500) nach einem der vorhergehenden Ansprüche,
wobei das Feldgerät ein Füllstandmessgerät, ein Grenzstandsensor, ein Durchflussmessgerät oder ein Druckmessgerät ist.

14. Feldgerät (500) nach einem der vorhergehenden Ansprüche,
wobei das Feldgerät ein autarkes, drahtloses Feldgerät ist.

15. Verfahren zur kompakten Anordnung von elektronischen Baugruppen einer Elektronikschaltung (100) eines Feldgeräts (500), welche zumindest eine erste Leiterplatte (104), eine zweite Leiterplatte (110) und eine dritte Leiterplatte (120) umfasst, aufweisen die Schritte:
elektrisches Verbinden einer zweiten Leiterplatte (110) mit einer dritten Leiterplatte (120) mittels einer Kabelverbindung (101);
Anordnen der zweiten Leiterplatte parallel zur dritten Leiterplatte;
Anordnen einer ersten Leiterplatte (104) über der zweiten Leiterplatte;
elektrisches Verbinden der ersten Leiterplatte mit der zweiten Leiterplatte und/oder mit der dritten Leiterplatte mittels einer elektrischen Steckverbindung.
